# EUROPEAN PATENT APPLICATION

(11) **EP 3 273 279 A1**
(43) Date of publication of application: **24.01.2018**
(21) Application number: 16768674.0
(22) Date of filing: 18.03.2016
(51) Int. Cl.: G02B 5/18, G02B 6/12, G02B 6/124

(54) **GRATING ELEMENT**

(30) Priority: 20.03.2015 JP 2015058383; 18.05.2015 JP 2015101040
(71) Applicant: NGK Insulators, Ltd., Nagoya-shi, Aichi 467-8530 (JP)
(72) Inventor: NIWA, Kousuke, Nagoya-shi, Aichi 467-8530 (JP); ASAI, Keiichiro, Nagoya-shi, Aichi 467-8530 (JP); YAMAGUCHI, Shoichiro, Nagoya-shi, Aichi 467-8530 (JP); KONDO, Jungo, Nagoya-shi, Aichi 467-8530 (JP)
(74) Representative: Müller-Boré & Partner Patentanwälte PartG mbB
(86) International application number: PCT/JP2016/058675
(87) International publication number: WO 2016/152771

(57) **Abstract**

A grating device includes a supporting body having a first main face and a second main face, an under clad layer provided on the first main face of the supporting body, an optical material layer provided on the under clad layer, and a back face layer provided on the second main face of the supporting body. The under clad layer is composed of g a material having a refractive index of 1.69 or lower. The optical material layer is composed of a metal oxide having a refractive index of 1.70 or higher and 3.50 or lower and includes a Bragg grating. The back face layer is composed of a material having a refractive index of 1.69 or lower or a metal oxide having a refractive index of 1.70 or higher and 3.50 or lower.

## Description

### TECHNICAL FIELD

The present invention relates to a grating element.

### BACKGROUND ARTS

According to patent document 1, it is described a method of producing a distributed feedback type semiconductor laser by applying nanoimprinting method. According to the method, patterning of a semiconductor layer for a grating of the distributed feedback type semiconductor laser is performed by the nanoimprinting method.

Further, non-Patent Documents 1 and 2 describe fabrication of a sub-wavelength structured wide-band wavelength plate using the nanoimprint method.

Further, Non-Patent Document 3 describes how the nanoimprint technology is applied to fabricate optical devices. Such optical devices include, for example, a wavelength selective element, a reflection control element, and a Moth-Eye structure.

For example, Patent document 3 discloses procedure for forming a diffraction grating by the nanoimprinting method.

When the diffraction grating is formed by nanoimprinting method, a resin layer is formed on a semiconductor layer in which the diffraction grating is to be formed. A mold having concave and convex pattern corresponding with the shape of the diffraction grating is then pressed onto the resin layer. In this state, the resin layer is exposed to irradiation of UV light having an optional wavelength or optical temperature condition so that the resin layer is cured. The concave and convex pattern of the mold is thereby transcripted onto the resin layer. Thereafter, a residual film of a resin is removed by dry etching treatment, and dry etching is performed so that the pattern of the resin layer is transcripted onto the semiconductor layer. A fine structure is thereby formed on the semiconductor layer.

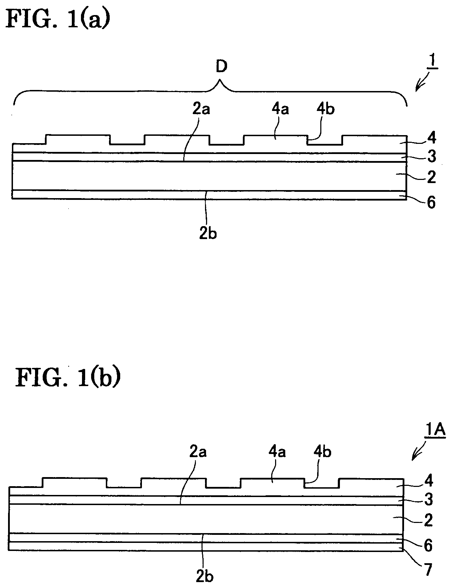

Further, according to description of patent document 4, it is necessary to remove the residual film after nanoimprinting according to prior procedure (0003 and Fig. 8). It is further described that its object is to provide a method of forming fine mask pattern in which the residual film is not present on the substrate or a thin pattern can be formed. Specifically, an inorganic material such as SOG or the like is embedded in a recess of a resin mold described in Fig. 1 or the like (spin coating and etch back, Fig. 1) and adsorbed onto the surface of the substrate. The resin mold is then released to form concaves and convexes whose precision is higher than that obtained by the nanoimprinting and removal of the residual film according to the prior arts.

[Patent Document 1] Japanese Patent Publication No. 2013-016650A
[Patent Document 2] Japanese Patent Publication No. 2009-111423A
[Patent Document 3] WO 2015/166852 A1
[Patent Document 4] Japanese Patent Publication No. 2011-066273A
[Patent Document 5] WO 2016/133161 A1

[Non-Patent Document 1]
   "Polymeric Wide-Band Wave Plate Produced via Nanoimprint Subwavelength Grating," KONICA MINOLTA TECHNOLOGY REPORT, Vol. 2 (2005), pages 97 to 100
[Non-Patent Document 2]
   "Challenge for production of highly-functional optical elements at low costs-Realization of sub-wavelength periodic structure by glass imprint method" Synthesiology, Vol. 1, No. 1 (2008), pages 24 to 30
[Non-Patent Document 3]
   Furuta, "Nanoimprint technology and its application to optical devices" monthly magazine "Display" June 2007, pages 54 to 61 [Non-Patent Document 4] "New technique for transcription of fine pattern" NTT technical journal, 2008, 10, pages 17 to 20

### SUMMARY OF THE INVENTION

The inventors have tried to form an optical waveguide layer over a supporting body via an under cladding layer with a concave-convex pattern having a pitch of several hundreds nanometers (Bragg grating pattern) on the surface of the optical waveguide layer.

However, when it was tried to produce many grating devices actually, it is proved that wavelengths are deviated among the produced grating devices and the wavelengths are not stabilized.

An object of the present invention is, in a grating device including a supporting body, an under clad layer and an optical material layer with Bragg grating formed therein, to reduce deviation of wavelengths among the thus produced grating devices.

The present invention provides a grating device comprising:
a supporting body including a first main face and a second main face;
an under clad layer provided on the first main face of the supporting body, the under clad layer comprising a material having a refractive index of 1.69 or lower;
an optical material layer provided on the under clad layer, comprising a metal oxide having a refractive index of 1.70 or higher and 3.50 or lower and comprising a Bragg grating formed therein; and
a back face layer provided on the second main face of the supporting body, the back face layer comprising a material having a refractive index of 1.69 or lower or a metal oxide having a refractive index of 1.70 or higher and 3.50 or lower.

The inventors studied the cause of the deviation of the wavelengths among the thus produced grating devices, and found the followings. That is, many Bragg grating patterns are formed in a single wafer on the viewpoint of productivity, and the respective grating patterns cut and separated from each other to obtain many chips of the respective grating devices. At this time, the wavelengths were deviated depending on the grating devices. As the pattern of the deviation is studied, it is proved that there is distribution of the deviation of the wavelengths depending on positions of the grating devices in the wafer.

Based on the findings, the present inventors tried to find the method of making the wavelengths of the grating devices, which are cut out from the respective positions of the wafer, uniform. In the course of study, by providing a back face layer, composed of a material belonging to the same category as the optical material layer or under clad layer, on a back face of the supporting body on the opposite side of the optical material layer of the grating device, it becomes possible to reduce the deviation of the wavelengths of the grating devices. The present invention is based on the findings.

### BRIEF DESCRIPTION OF DRAWINGS

Figs. 1(a) and 1(b) are side views schematically showing grating devices 1 and 1A, respectively, according to the present invention.
Figs. 2(a), 2(b) and 2(c) are side views schematically showing grating devices 1B, 1C and 1D, respectively.
Fig. 3 (a) shows an assembly 13 including a back face layer 6, supporting body 2, under clad layer 3, optical material layer 4A, underlying layer 11 and resin layer 12, Fig. 3(b) shows the state that a design pattern A of a mold 13 is transcripted to a resin layer 12A, and Fig. 3(c) shows the state that a fine pattern B is transcripted to the resin layer 12A.
Fig. 4(a) shows the state that a resin layer 12B and underlying layer 11B are patterned to form openings 12d, 11a, Fig. 4(b) shows the state that a fine pattern is formed in an optical material layer 4 using an underlying layer 11C as a mask, and Fig. 4(c) shows the state that the underlying layer 11C is removed.
Fig. 5 is a photograph showing a grating pattern formed in the inventive Example.
Fig. 6 is a view schematically showing positions of cutting out of grating devices in a wafer, according to the inventive and comparative examples.

### MODES FOR CARRYING OUT THE INVENTION

The present invention will be described in more detail below, with reference to the accompanying drawings as appropriate.

Fig. 1(a) schematically shows a grating device 1 according to the present invention. An under clad layer 3 and optical material layer 4 are formed on a first main face 2a of a supporting body 2. A back face layer 6 is formed on a second main face 2b on the opposite side of the supporting body 2. A grating pattern D composed of repetition of convexes 4a and concaves 4b is formed on a surface of the optical material layer 4.

According to a grating device 1A shown in Fig. 1(b), a plurality of, for example two, layers of back face layers 6 and 7 are formed on a second main face 2b of the supporting body 2. However, same numerals are assigned to parts already shown in Fig. 1(a) and the descriptions are omitted.

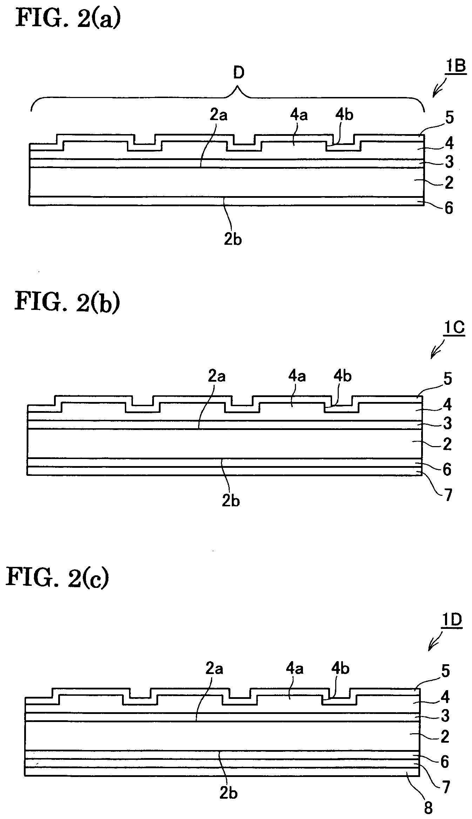

According to a grating device 1B shown in Fig. 2(a), an upper clad layer 5 is further provided on the grating pattern D of the optical material layer 4.

According to a grating device 1C shown in Fig. 2(b), the upper clad layer 5 is provided on the grating pattern D of the optical material layer 4, and a plurality of the back face layers 6 and 7 are provided on the second main face 2b of the supporting body 2.

According to a grating device 1D shown in Fig. 2(c), the upper clad layer 5 is provided on the grating pattern D of the optical material layer 4, and a plurality of back face layers 6, 7 and 8 are provided on the second main face 2b of the supporting body 2.

The grating pattern formed on the optical material layer may preferably be a pattern having a single period of 10 *µ* m or smaller, and it is particularly preferred for a pattern having a single period of 1*µ* m or smaller.

The under clad layer (and optionally the upper clad layer) is composed of a material having a refractive index of 1.69 or lower. Further, such material may be selected as a material of the back face layer.

The refractive index of the material is 1.69 or lower, may preferably be 1.60 or lower, and more preferably be 1.55 or lower. Although the lower limit of the refractive index of the material is not particularly limited, it is normally 1.35 or higher.

The material having a refractive index of 1.69 or lower may preferably be SiO₂, an SiO₂ based glass or Al₂O₃. The SiO₂ based glass includes quartz glass, borosilicate glass, soda lime glass or the like.

By making the thickness of the lower clad layer or upper clad layer large, the leakage of the propagating light into the supporting body can be reduced. On the viewpoint, the thickness of each of the clad layers may preferably be made 0.5 *µ* m or larger. Further, although the upper limit of each clad layer is not particularly defined, it may be made 3 *µ* m or smaller on the viewpoint of reducing loss. The reason is as follows. As the film thickness is made larger, the film quality tends to be deteriorated so that the optical loss becomes larger.

Further, the material of the lower and upper clad layers may be doped so that the refractive indices thereof can be adjusted. Such dopant includes P, B, Al and Ga.

According to the present invention, the material forming the optical material layer is a metal oxide having a refractive index of 1.70 or higher and 3.50 or lower. The material of the back face layer may be selected from the metal oxides.

The refractive index of the metal oxide may preferably be 3.0 or lower, and preferably be 1.80 or higher. Further, specifically, such metal oxide may preferably be lithium niobate, lithium tantalate, lithium niobate-lithium tantalate solid solution, tantalum oxide, zinc oxide, alumina, titanium oxide, niobium oxide, or magnesium oxide.

The metal oxide forming the optical material layer may contain one or more kinds of metal elements selected from the group consisting of magnesium (Mg), zinc (Zn), scandium (Sc), and indium (In). In this case, magnesium is particularly preferable. Crystals of the optical material layer may contain a rare-earth element as a doping agent. Suitable rare-earth elements include, particularly preferably, Nd, Er, Tm, Ho, Dy, and Pr.

The thickness of the optical material layer is not particularly limited. In terms of reducing the propagation loss of light, the thickness of the optical material layer is preferably in a range of 0.5 to 3 µm.

Specific materials for the supporting body are not particularly limited, but includes, for example, lithium niobate, lithium tantalate, lithium niobate-lithium tantalate solid solution, aluminum nitride, silicon nitride, zinc oxide, a glass such as silica glass, synthetic silica, quartz crystal, sapphire, Si or the like.

The thickness of the supporting body is preferably 250 µm or more in terms of handling, and preferably 1mm or less in terms of downsizing.

As the material of the back face layer, it is selected the metal oxide described above or a material having a refractive index of 1.69 or lower. Here, in the case that the back face layer is formed of the metal oxide, the metal oxide may be same as or different from the metal oxide forming the optical material layer, and they are preferably the same. Further, in the case that the back face layer is formed of the material having a refractive index of 1.69 or lower, the material having a refractive index of 1.69 or lower may be same as or different from the material having a refractive index of 1.69 or lower forming the under clad layer, and they are preferably the same.

For example, as shown in Figs. 1(b), 2(b) and 2(c), in the case that back face layers 6 and 7 are provided sequentially on the second main face of the supporting body, the material of the back face layer 6 near the supporting body may preferably be the material having a refractive index of 1.69 or lower, and the material of the back face layer provided on the back face layer 6 may preferably be the metal oxide having a refractive index of 1.70 or higher.

Further, for example, as shown in Fig. 2(c), in the case that a back face layer 8 is further provided on the back face layer 7, the material of the back face layer 8 may preferably be the material having a refractive index of 1.69 or lower.

On the viewpoint of the effects of the present invention, the thickness of the back face layers (total value) may preferably be 0.5 *µ* m or larger and more preferably be 0.9 *µ* m or larger. Further, on the viewpoint of making the temperature distribution of an electrostatic chuck in performing dry etching uniform, the thickness (total value) of the back face layer(s) may preferably be 3*µ* m or smaller and more preferably be 2*µ* m or smaller.

Preferred embodiment of producing the inventive grating device will be described below.

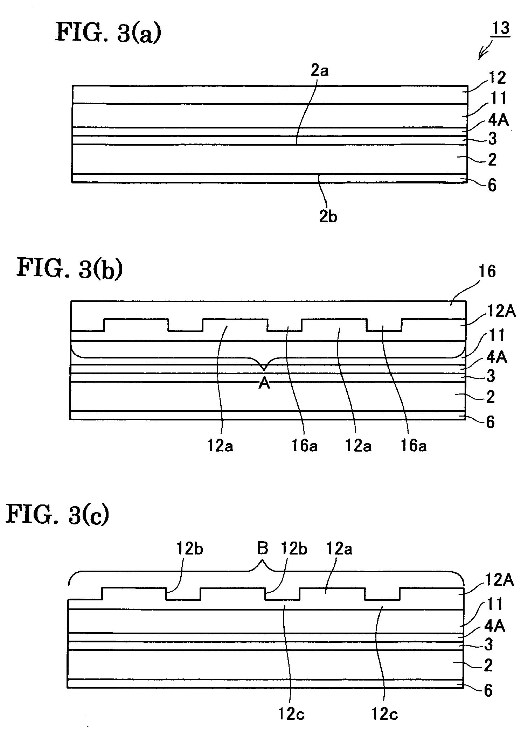

First, as shown in Fig. 3(a), an under clad layer 3 and optical material layer 4A are formed on a first main face 2a of a supporting body 2, and an underlying layer 11 and resin layer 12 are formed thereon. At the same time, a back face layer 6 is formed on a second main face 2b of the supporting body 2. An assembly 13 is thus obtained.

Then, as shown in Fig. 3(b), a mold 16 is contacted with the resin layer to transcript a design pattern A of the mold onto a resin layer 12A. The design pattern A of the mold 16 is composed of many convexes 5a periodically formed, for example, and a resin 12a is filled into spaces between the adjacent convexes 16a.

Then, the mold 16 is removed to obtain the resin layer 12A onto which a fine pattern B is transcripted, as shown in Fig. 3(c). 12a represents a convex and 12b represents a concave between the convexes.

Here, although unnecessary resin is left as a residual film 12c under the concaves 12b, the ashing for removing the residual resin film is not performed, according to the present example.

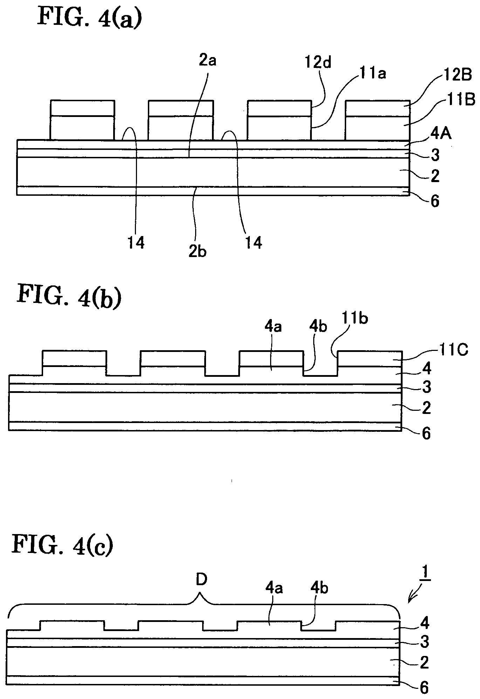

That is, the resin layer 12A and underlying layer 11 are etched at this stage. By the etching, the whole of the resin layer 12A is removed, and the underlying layer 11 is exposed in the concaves 12b with the residual film 12c at first, and the etching of the underlying layer is then initiated. As a result, as shown in Fig. 4(a), openings 12d are formed in s resin layer 12B, and the underlying layer 11B is etched under the openings 12d to form openings 11a. A surface 14 of the optical material layer 4A is exposed through the openings 12d and 11a.

At this stage, the resin residual film is removed, and at the same time, the removal of the underlying layer provided under the residual film is proceeded, so that the etching of the underlying layer becomes a main step. As a result, in the case that the thickness of the resin residual film is deviated, the influence of the deviation is reduced during the step of performing the etching of the underlying layer. Further, as it is easier to etch the underlying layer made of a metal or a metal silicide than a metal oxide, it is possible to prevent the deterioration of the shape of the resin mask 12B during the process of the etching of the underlying layer.

Then, as shown in Fig. 4(b), the optical material layer is etched to form convexes 4b and concaves 4a of a predetermined pattern. After the etching on this stage, the resin layer is removed and the underlying layer 11C functioning as a mask is also thinned. Openings 11b are formed in the underlying layer 11C, and concaves 4b are exposed through the openings 11b.

The remained underlying layer 11C is then removed to expose the optical material layer 4 shown in Fig. 4(c). A fine pattern D is formed on the optical material layer 4, and is composed of convexes 4a and concaves 4b formed at a predetermined interval.

According to the present example of production, the underlying layer 11B is used as a mask to etch the optical material layer 4. In this case, it becomes possible to apply etching conditions and etchant which can prevent the etching of the metal and facilitate the etching of the metal oxide. It is thus possible to form deeper concaves at a higher precision.

When imprinting a design pattern of a mold and a resin layer is composed of a thermoplastic resin, the resin layer is softened by being heated up at a softening point of the resin or higher and the mold is pressed against the resin layer, allowing the resin to be deformed. After being cooled down, the resin layer is cured.

When the resin layer is made of a thermosetting resin, the mold is pressed against the uncured resin layer, causing the resin to be deformed. Subsequently, the resin layer is heated up at a polymerization temperature of the resin or higher, and thereby can be cured. When the resin layer is formed of a photo curable resin, the mold is pressed against the uncured resin layer, thereby deforming the resin to transfer the designed pattern to the resin layer. Then, the resin layer is irradiated with light and thereby can be cured.

The material of the underlying layer provided under the resin layer is a metal or a metal silicide.

The metal forming the underlying layer includes Ti, Cr, Mo, W, Ta, Si, Ni, Al, V, Fe, Nb, Re, Co, Pd, Pt or the alloys thereof.

Further, the metal silicide forming the underlying layer includes tungsten silicide, vanadium silicide, iron silicide, niobium silicide, molybdenum silicide, rhenium silicide, chromium silicide, cobalt silicide, nickel silicide, palladium silicide and platinum silicide.

More preferably, the metal forming the underlying layer is Ti, Cr, Ni, Al or the alloys thereof.

The optical material layer, lower clad layer, upper clad layer and underlying layer may be a single layer, or alternatively a multi-layer film.

The optical material layer, lower clad layer, upper clad layer and underlying layer may be formed by a thin-film formation method. Suitable thin-film formation methods include sputtering, vapor deposition, and CVD.

When the resin layer or underlying layer is etched, the following method is preferred.

That is, in selecting a gas species in performing dry etching, it is preferred that a selection ratio of an etching rate of the resin and that of the metal or metal silicide is large and that the gas species does not etch the metal oxide layer. As the dry etching method using the gas species, it is listed ICP (induction coupling plasma) dry etching. As the gas species, a chlorine based gas such as BCl₃ or Cl₂ is listed as an example, and a fluorine based gas may be used.

According to the present example of production, when the resin layer and underlying layer are etched, both layers can be etched in a single etching step. By this, the separate step of the treatment of the residual film (ashing) of the resin film becomes unnecessary. Here, the single ethcing step means a step that the assembly is contacted with the echant to perform the etching until the contact of the assembly to the etchant is terminated. During the etching step, the gas species is preferably of a single kind, although the kind and composition of the gas species may be changed.

When the optical material layer 4 is etched using the underlying layer as a mask, as shown in Fig. 4(b), the following etching method is preferred. That is, in selecting a gas species in performing dry etching, it is preferred that a selection ratio of an etching rate of the metal or metal silicide and that of the metal oxide is large. As the dry etching method using the gas species, it is listed ICP (induction coupling plasma) dry etching. As the gas species, a fluorine based gas such as CHF₃, C₂F₆ or the like is listed as an example, although it is not restrictive.

### EXAMPLES

The Bragg grating device 1B shown in Fig. 2(a) was produced, according to the method described referring to Figs 3 and 4.

Specifically, on a first main face 2a of a supporting body (wafer) 2 made of Si and of a diameter *φ* of 6 inches, a lower clad layer 3 made of SiO₂ was formed as a film in 1.0*µ* m, and an optical material layer 4A of Ta₂O₅ was formed on the surface in 1.2*µ* m. Further, an underlying layer 11 (thickness of 50nm) made of Ti was formed on the upper surface by sputtering. Then, a back face layer 6 composed of SiO₂ and with a thickness of 0.95 *µ* m was formed on a second main face 2b of the supporting body 2 by reactive sputtering on the underlying layer 11. A nanoimprint resin layer 12 was then applied on the underlying layer 11 to obtain an assembly 13.

The mold 16 was then pressed, the curing was performed by ultraviolet light, and the mold was released, so that the grating mask pattern B was formed on the resin layer 12A. Then, by dry etching using a chlorine based gas (BCl₃) and the resin mask pattern as a mask, the underlying layer 11B was etched to the surface of the optical material layer 4A, and the residual film of the resin was removed at the same time. Further, the optical material layer 4A was subjected to dry etching by using a fluorine based gas (CHF₃) and the underlying film 11B as a mask, so that the etching was continued until a depth of 100nm. The residue of the underlying layer 11C was then removed.

As described above, it was formed a Bragg grating D having a pitch of 197nm, a depth of 100nm and a duty ratio of 1:1. The grating part had the shape that concaves 4b were formed downwardly with respect to the surface of the optical material layer 4 as a standard level.

The pitch was measured in a transcripted region of 200*µ* m in length and 200 *µ* m in width using an AFM capable of high precision measurement of ±0.04nm or smaller and a measuring system using diffraction ray of laser light. As a result, over the whole of the wafer plane of *φ* 6 inches, it could be obtained a desired pitch of ultra-high precision of 197±0.1nm, ever when it was measured the grating of a small transcripted region (small pattern density).

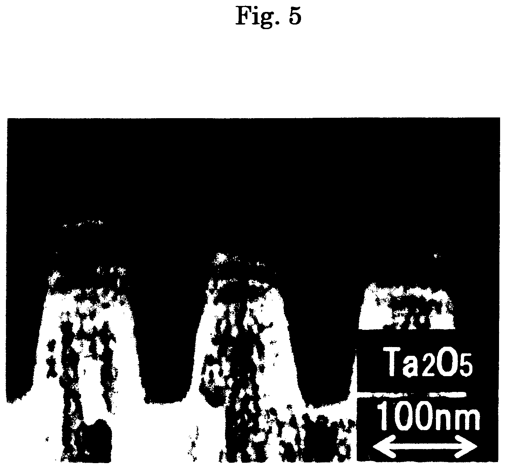

Fig. 5 shows an SEM (scanning type electron microscope) photograph of the thus obtained Bragg grating (magnification of 100, 000 fold). It was proved that deep convexes were formed and the shape of each convex was near a rectangular shape.

Further, for forming an optical waveguide, dry etching was performed using the fluoride based gas (CHF₃) according to the same procedure as described above, so that it was formed a ridge type optical waveguide including a straight part having a ridge width of 3 *µ* m and ridge depth of 0.6 *µ* m. It was then formed SiO₂ layer in 1*µ* m as an upper clad layer 5.

The thus obtained part was then cut out into bars by a dicing system, and both end faces of the bar was subjected to optical polishing. AR coatings were formed on both end faces, respectively, and the bar was finally cut out into chips to produce grating devices. As to the sizes of the device, the width was made 2mm and length was made 10mm.

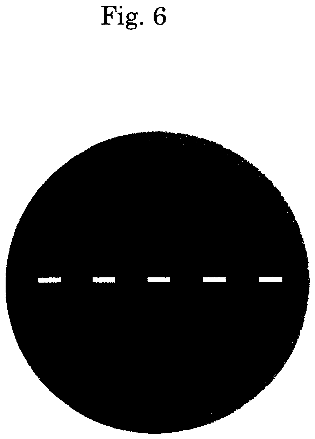

Among the thus produced devices, optical properties were measured for five devices cut from the wafer at five positions shown in Fig. 6 (positions 1, 2, 3, 4 and 5 for cutting). Here, an interval of 35mm was provided between the five positions for cutting in horizontal direction. A super luminescent diode (SLD) as a broadband wavelength light source was used to input the light in the TE mode into the grating device to analyze the output light therefrom by means of an optical spectrum analyzer, thereby evaluating the reflection characteristics from the transmission characteristics. The results were shown in table 1.

**Table 1**

| | Positions for cutting | | | | |
|---|---|---|---|---|---|
| Target Wavelength | 4 | 2 | 1 | 3 | 5 |
| 830.0 nm | 830.0 nm | 830.1 nm | 829.9 nm | 830.1 nm | 829.9 nm |

It was confirmed that the reflection wavelengths of the five devices were within a range of 830.0nm (target wavelength) ±0.1nm.

Further, it was shown only results of pitches and reflection wavelengths of the devices cut at the five positions distant horizontally by 35 mm from each other of the wafer. However, it was further confirmed that the similar results of deviations of the pitches and reflective wavelengths were obtained in the devices cut at five positions distant by 35mm in the vertical direction of the wafer.

### (Comparative Example 1)

It was produced a wafer with many grating devices formed therein as described in the Example 1.

However, different from the Example 1, the back face layer 6 was not formed on the second main face 2b of the supporting body 2. It was thus obtained the grating device as the Example 1 except the absence of the back face layer 6.

In the thus obtained Bragg grating pattern, it was formed concaves whose depths were comparable with that obtained in the Example 1, and that the shape of the concave was similar to a rectangle, based on an image obtained by a scanning type electron microscope (SEM).

Then, the pitch was measured in the transcripted region of 200 *µ* m in length and 200 *µ* m in width using an AFM capable of high precision measurement of ± 0.04nm or smaller and a measuring system using diffraction ray of laser light. As a result, the pitches were proved to be 197±0.2nm, which was inferior to that of the Example 1 in the precision of pitch.

Further, a ridge type optical waveguide was formed as the Example 1 and the upper buffer layer 5 was formed thereon. Thereafter, many grating devices 1B were formed on the wafer according to the same process as described above.

Among the thus produced devices, optical properties were measured for five devices cut from the wafer at five positions shown in Fig. 6. Here, an interval of 35mm was provided between the five positions for cutting in horizontal direction. A super luminescent diode (SLD) as a broadband wavelength light source was used to input the light in TE mode into the grating device to analyze the output light therefrom by means of an optical spectrum analyzer, thereby evaluating the reflection characteristics from the transmission characteristics. The results were shown in table 2.

**Table 2**

| | Positions for cutting | | | | |
|---|---|---|---|---|---|
| Target wavelength | 4 | 2 | 1 | 3 | 5 |
| 830.0 nm | 830.6 nm | 830.3 nm | 830.1 nm | 830.2 nm | 830.5 nm |

It was confirmed that the reflection wavelengths of the five devices were within a range of target wavelength (830.0nm) ± 0.6nm and that the reflection wavelengths were deviated compared with the Example 1.

Further, it was shown only results of pitches and reflection wavelengths of the devices cut at the five positions distant horizontally by 35 mm from each other of the wafer. However, it was further confirmed that the similar results of deviations of the pitches and reflective wavelengths were obtained in the devices cut at five positions distant by 35mm in the vertical direction of the wafer.

### (Example 2)

It was produced a grating device as described in the Example 1. However, different from the Example 1, the material of the back face layer 6 was made Ta₂O₅.

Then, the pitch was measured in the transcripted region of 200*µ* m in length and 200*µ* m in width using an AFM capable of high precision measurement of ± 0.04nm or smaller and a measuring system using diffraction ray of laser light as the Example 1. As a result, the pitches were proved to be 197±0.1nm.

Further, as the Example 1, among the thus produced devices, optical properties were measured for five devices cut out from the five positions, respectively, shown in Fig. 6 of the wafer. As a result, the refractive wavelengths of the five devices were proved to be the target wavelength (830.0nm) ± 0.1nm.

## Claims

1. A grating device comprising:
a supporting body including a first main face and a second main face;
an under clad layer provided on said first main face of said supporting body, said under clad layer comprising a material having a refractive index of 1.69 or lower;
an optical material layer provided on said under clad layer, comprising a metal oxide having a refractive index of 1.70 or higher and 3.50 or lower and comprising a Bragg grating formed in said optical material layer; and
a back face layer provided on said second main face of said supporting body, said back face layer comprising a material having a refractive index of 1.69 or lower or a metal oxide having a refractive index of 1.70 or higher and 3.50 or lower.

2. The grating device of claim 1, further comprising an upper clad layer provided on said optical material layer, said upper clad layer comprising a material having a refractive index of 1.69 or lower.

3. The grating device of claim 1, wherein said material having said refractive index of 1.69 or lower comprises SiO₂, an SiO₂ based glass or Al₂O₃.
